# EUROPEAN PATENT APPLICATION

(11) **EP 4 693 769 A1**
(43) Date of publication of application: **11.02.2026**
(21) Application number: 24780347.1
(22) Date of filing: 26.03.2024
(51) Int. Cl.: H01S 5/024

(54) **OPTICAL TRANSCEIVER**

(30) Priority: 30.03.2023 WO PCT/JP2023/013262
(71) Applicant: NGK Insulators, Ltd., Nagoya-shi, Aichi 467-8530 (JP)
(72) Inventor: EBIGASE, Takashi, Nagoya-shi, Aichi 467-8530 (JP); KAJIURA, Yohei, Nagoya-shi, Aichi 467-8530 (JP)
(74) Representative: Müller-Boré & Partner Patentanwälte PartG mbB
(86) International application number: PCT/JP2024/012023
(87) International publication number: WO 2024/204239

(57) **Abstract**

A Peltier element (PD) includes a first aluminum nitride substrate (211), a second aluminum nitride substrate (212), and a body (301) supported between them. The body (301) includes at least one semiconductor member (30), at least one first metal member (35), and at least one second metal member (35), the at least one first metal member and the at least one second metal member sandwiching the at least one semiconductor member. A laser chip (101) is mounted to a first surface of the first aluminum nitride substrate (211). A lens (110) is disposed off the first aluminum nitride substrate (211) in a planar layout to intersect an imaginary plane (IP) including the first surface. A wiring pattern (280) is electrically connected to the laser chip (101) and is disposed directly on the first surface.

## Description

### TECHNICAL FIELD

The present invention relates to optical transceivers.

### BACKGROUND ART

Japanese Patent Application Laid-Open No. 2006-229067 (Patent Document 1) discloses an optical transceiver module transmitting and receiving signal light to and from an optical fiber. The optical transceiver module includes a laser diode generating signal light, a Peltier element to adjust a temperature of the laser diode, and a package containing therein the laser diode and the Peltier element.

US Patent Application Publication No. 2021/0063685 (Patent Document 2) discloses several forms of an optical device. One form of the optical device includes an enclosure including an optical aperture, optical components positioned within the enclosure and emitting or receiving light through the aperture, and a cooling element being for providing an isothermal environment to the optical components and thermally coupled with the enclosure.

### PRIOR ART DOCUMENTS

### PATENT DOCUMENTS

Patent Document 1: Japanese Patent Application Laid-Open No. 2006-229067
Patent Document 2: US Patent Application Publication No. 2021/0063685

### SUMMARY

### PROBLEM TO BE SOLVED BY THE INVENTION

Reduction in power consumption, size, and member costs of an optical transceiver has recently been sought. A configuration for cooling of the optical transceiver has not sufficiently been studied from these viewpoints.

The present disclosure has been conceived to solve a problem as described above, and it is one object of the present disclosure to provide an optical transceiver capable of reducing consumption energy relating to cooling of the optical transceiver. It is another object to provide an optical transceiver capable of reducing a size of the optical transceiver including a configuration for cooling. It is yet another object to provide an optical transceiver capable of reducing member costs relating to cooling.

### MEANS TO SOLVE THE PROBLEM

Aspect 1 is an optical transceiver for emitting output light in response to an input electric signal, the optical transceiver including a Peltier element including: a first aluminum nitride substrate having a single layer structure and having a first surface and a second surface opposite the first surface; a second aluminum nitride substrate having a single layer structure, disposed away from the first aluminum nitride substrate in one direction, and facing the second surface; and a body supported between the first aluminum nitride substrate and the second aluminum nitride substrate, the body including: at least one semiconductor member; at least one first metal member being in contact with the at least one semiconductor member; and at least one second metal member being in contact with the at least one semiconductor member, the at least one first metal member and the at least one second metal member sandwiching the at least one semiconductor member, wherein the optical transceiver further includes: a laser chip to generate laser light, the laser chip being mounted to the first surface of the first aluminum nitride substrate of the Peltier element; a lens disposed off the first aluminum nitride substrate in a planar layout perpendicular to the one direction, the lens being disposed to intersect an imaginary plane including the first surface of the first aluminum nitride substrate of the Peltier element and to allow the laser light from the laser chip to pass therethrough; and a wiring pattern electrically connected to the laser chip and disposed directly on the first surface of the first aluminum nitride substrate.

Aspect 2 is the optical transceiver according to Aspect 1, wherein the first surface of the first aluminum nitride substrate is a flat surface.

Aspect 3 is the optical transceiver according to Aspect 1 or 2, further including a heat sink supporting the second aluminum nitride substrate and including metal.

Aspect 4 is an optical transceiver for emitting output light in response to an input electric signal, the optical transceiver including: a laser chip to generate laser light; a lens disposed off the laser chip in a planar layout to allow the laser light from the laser chip to pass therethrough; and at least one aluminum nitride substrate, the at least one aluminum nitride substrate including a first aluminum nitride substrate having a first surface to which the laser chip is mounted and a second surface opposite the first surface, each of the at least one aluminum nitride substrate being disposed off the lens in the planar layout, wherein the optical transceiver further includes a support substrate supporting the first aluminum nitride substrate, the support substrate including at least one metal via and an insulator layer in which the at least one metal via is embedded, the at least one metal via having a first end oriented toward the first aluminum nitride substrate and a second end opposite the first end, the first end of the at least one metal via at least partially overlapping the first aluminum nitride substrate in the planar layout, the optical transceiver further includes a cooler connected to the second end of the at least one metal via, and the first aluminum nitride substrate does not include a metal via.

Aspect 5 is the optical transceiver according to Aspect 4, wherein the cooler includes a Peltier element.

Aspect 6 is the optical transceiver according to Aspect 5, wherein the Peltier element includes at least one semiconductor member, the at least one semiconductor member each has a p type and does not include an n type semiconductor member, or the at least one semiconductor member each has an n type and does not include a p type semiconductor member, and the at least one semiconductor member has a bonded surface bonded to a metal material, and the bonded surface is electrically connected to the at least one metal via.

Aspect 7 is the optical transceiver according to any one of Aspects 4 to 6, wherein the support substrate has at least one through hole, and the at least one metal via entirely fills the at least one through hole.

Aspect 8 is the optical transceiver according to any one of Aspects 4 to 7, wherein the lens is supported by the support substrate, and the insulator layer of the support substrate includes alumina.

Aspect 9 is an optical transceiver for emitting output light in response to an input electric signal, the optical transceiver including: a laser chip to generate laser light; and a support substrate supporting the laser chip, wherein the support substrate includes at least one metal via and an insulator layer in which the at least one metal via is embedded, the at least one metal via having a first end oriented toward the laser chip and a second end opposite the first end, the optical transceiver further includes a cooler connected to the second end of the at least one metal via, the laser chip is mounted to the support substrate, and the first end of the at least one metal via at least partially overlaps the laser chip in a planar layout, the cooler includes a Peltier element including at least one semiconductor member, and the at least one semiconductor member each has a p type and does not include an n type semiconductor member, or the at least one semiconductor member each has an n type and does not include a p type semiconductor member, and the at least one semiconductor member has a bonded surface bonded to a metal material, and the bonded surface is electrically connected to the at least one metal via.

### EFFECTS OF THE INVENTION

According to the present disclosure, consumption energy relating to cooling of the optical transceiver can be reduced. A size of the optical transceiver including a configuration for cooling can also be reduced. Furthermore, member costs relating to cooling can be reduced.

These and other objects, features, aspects and advantages of the present invention will become more apparent from the following detailed description when taken in conjunction with the accompanying drawings.

### BRIEF DESCRIPTION OF DRAWINGS

[FIG. 1] is a block diagram schematically showing a configuration of an optical transceiver.
[FIG. 2] is a cross-sectional view schematically showing a configuration of an optical transceiver according to a comparative example.
[FIG. 3] is a plan view schematically showing a laser chip of an optical transceiver and a wiring pattern, components, and a temperature sensor arranged around the laser chip.
[FIG. 4] is a cross-sectional view schematically showing a configuration of an optical transceiver according to Embodiment 1.
[FIG. 5] is a cross-sectional view schematically showing a configuration of an optical transceiver according to Embodiment 2.
[FIG. 6] is a cross-sectional view schematically showing a configuration of an optical transceiver according to Embodiment 3.
[FIG. 7] is a cross-sectional view schematically showing a configuration of an optical transceiver according to Embodiment 4.
[FIG. 8] is a cross-sectional view schematically showing a configuration of an optical transceiver according to Embodiment 5.
[FIG. 9] is a cross-sectional view schematically showing a configuration of an optical transceiver according to Embodiment 6.
[FIG. 10] is a cross-sectional view schematically showing a configuration of an optical transceiver according to Embodiment 7.
[FIG. 11] is a perspective view illustrating simulation conditions of a comparative example.
[FIG. 12] is a side view illustrating the simulation conditions of the comparative example.
[FIG. 13] is a perspective view illustrating simulation conditions of Example A.
[FIG. 14] is a side view illustrating the simulation conditions of Example A.
[FIG. 15] is a perspective view illustrating simulation conditions of Example B.
[FIG. 16] is a side view illustrating the simulation conditions of Example B.
[FIG. 17] is a cross-sectional view corresponding to a field of view of FIG. 15 of Example B.
[FIG. 18] is a cross-sectional view corresponding to a field of view of FIG. 16 of Example B.
[FIG. 19] is a partial perspective view illustrating the simulation conditions of Example B from a different direction from that of FIG. 15.
[FIG. 20] is a perspective view showing a heat dissipating portion under the simulation conditions of Example B.
[FIG. 21] is a cross-sectional view showing a simulation result of temperature distribution of the comparative example.
[FIG. 22] is a cross-sectional view showing a simulation result of temperature distribution of Example A.
[FIG. 23] is a cross-sectional view showing a simulation result of temperature distribution of Example B.
[FIG. 24] is a cross-sectional view showing a simulation result of heat flux distribution of the comparative example.
[FIG. 25] is a cross-sectional view showing a simulation result of heat flux distribution of Example A.
[FIG. 26] is a cross-sectional view showing a simulation result of heat flux distribution of Example B.

### DESCRIPTION OF EMBODIMENTS

### <Preliminary Description>

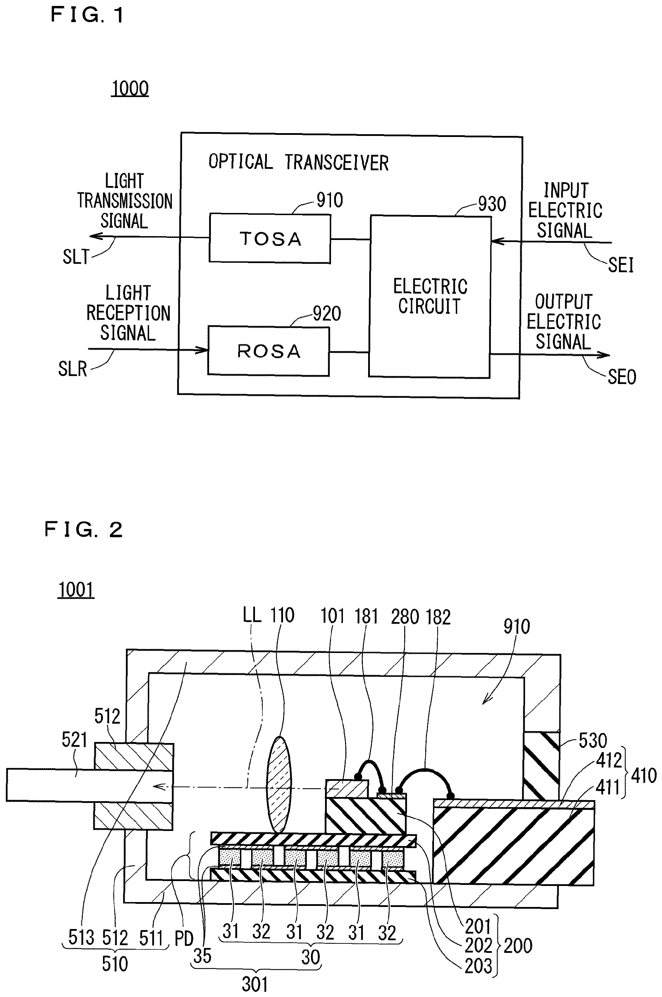

FIG. 1 is a block diagram schematically showing a configuration of an optical transceiver 1000. The optical transceiver 1000 includes a transmitter optical sub-assembly (TOSA) 910, a receiver optical sub-assembly (ROSA) 920, an electric circuit 930, and a housing containing them.

The TOSA 910 outputs a light transmission signal SLT in response to an electric signal from the electric circuit 930. The TOSA 910 includes a laser chip as a light emitting element to generate the light transmission signal SLT. The laser chip is an electro-absorption modulator laser diode (EML) laser chip, for example.

The ROSA 920 outputs an electric signal to the electric circuit 930 in response to a light reception signal SLR. The ROSA 920 includes a light receiving element to convert the light reception signal SLR into the electric signal. The light receiving element is a photodiode element, for example.

The electric circuit 930 outputs the electric signal to control the TOSA 910 in response to an input electric signal SEI. The electric circuit 930 also outputs an output electric signal SEO in response to the electric signal from the ROSA 920. The electric circuit 930 may include a digital signal processor (DSP) to process the signal to the TOSA 910 or the signal from the ROSA 920. The electric circuit 930 may also include a driver to drive the laser chip of the TOSA 910, in other words, a laser driver. The laser driver may be disposed between the TOSA 910 and the DSP. The electric circuit 930 may also include a micro controller unit (MCU) (micro controller). The electric circuit 930 may also include a power supply.

As described above, the optical transceiver 1000 is for emitting the light transmission signal SLT (output light) in response to the input electric signal SEI. The optical transceiver 1000 is also for outputting the output electric signal SEO in response to the light reception signal SLR (input light).

A comparative example and embodiments described below have the above-mentioned configuration in common, and description on the configuration is not repeated.

### <Comparative Example>

FIG. 2 is a cross-sectional view schematically showing a configuration of an optical transceiver 1001 according to the comparative example. The optical transceiver 1001 includes a laser chip 101, a lens 110, and aluminum nitride substrates 201 to 203 as a plurality of aluminum nitride substrates 200.

The laser chip 101 is to generate laser light LL. The lens 110 is disposed off the laser chip 101 in a planar layout, and the same applies to the embodiments described below. The planar layout herein means a layout in a plane perpendicular to a thickness direction (vertical direction in FIG. 2). The lens 110 is disposed to allow the laser light LL from the laser chip 101 to pass therethrough. An alternate long and short dashed line in the figure represents an optical axis of the laser light LL. The aluminum nitride substrate 201 has an upper surface to which the laser chip 101 is mounted and a lower surface opposite the upper surface. The aluminum nitride substrate 202 has an upper surface supporting the lower surface of the aluminum nitride substrate 201 and a lower surface opposite the upper surface. The lens 110 is stacked over the upper surface of the aluminum nitride substrate 202 without being separated by any of the aluminum nitride substrates 200. On the other hand, the laser chip 101 is stacked over the upper surface of the aluminum nitride substrate 202 while being separated by the aluminum nitride substrate 203.

The optical transceiver 1001 includes a Peltier element PD (cooler). The Peltier element PD includes a pair of aluminum nitride substrates and a body 301 supported between them. In the present embodiment, the above-mentioned pair of aluminum nitride substrates includes the aluminum nitride substrate 202 and the aluminum nitride substrate 203. The aluminum nitride substrate 202 of the Peltier element PD may be adhered to the aluminum nitride substrate 201 with an adhesive layer (not illustrated) including a different material from aluminum nitride, and the adhesive layer is a silicone adhesive sheet, for example. The aluminum nitride substrate 203 of the Peltier element PD may be adhered to a heat sink 511 with an adhesive layer (not illustrated) including a different material from aluminum nitride, and the adhesive layer is a silicone adhesive sheet, for example.

The body 301 of the Peltier element PD is attached to the lower surface of the aluminum nitride substrate 202 to cool the laser chip 101. The body 301 includes a plurality of semiconductor members 30 and a plurality of metal members 35. The plurality of metal members 35 include at least one metal member (first metal member) disposed on one side (an upper side in FIG. 2) in the thickness direction (vertical direction in FIG. 2) and at least one metal member (second metal member) disposed on the other side (a lower side in FIG. 2) in the thickness direction. The semiconductor members 30 are each sandwiched between metal members 35. The first and second metal members are each in contact with a semiconductor member 30. The first and second metal members sandwich the semiconductor members 30 in the thickness direction. The plurality of semiconductor members 30 include p type semiconductor members 31 and n type semiconductor members 32. The p type semiconductor members 31 and the n type semiconductor members 32 are alternatingly connected in series via the metal members 35. The aluminum nitride substrate 203 and the aluminum nitride substrate 202 sandwich the body 301. In other words, the body 301 is disposed between the aluminum nitride substrate 202 and the aluminum nitride substrate 203. The body 301 is thereby supported between the aluminum nitride substrate 202 and the aluminum nitride substrate 203.

The optical transceiver 1001 includes the heat sink 511. The heat sink 511 supports the aluminum nitride substrate 203. The heat sink 511 includes metal, and the metal is steel use stainless (SUS), for example. The heat sink 511 constitutes a housing 510 having a sealed internal space together with a wall 512 and a lid 513.

The optical transceiver 1001 includes a wiring substrate 410. The wiring substrate 410 includes an insulator layer 411 and a wiring pattern 412 disposed over the insulator layer 411. The insulator layer 411 may be made of an inexpensive material different from aluminum nitride and is made of alumina, for example. The laser chip 101 is electrically connected to the wiring pattern 412. The wiring substrate 410 includes a portion protruding outside the housing 510, and the wiring pattern 412 is exposed in the portion. The wiring pattern 412 and the housing 510 may be bonded by a bonding material 530.

A wiring pattern 280 is disposed over the upper surface of the aluminum nitride substrate 201. The wiring pattern 280 is electrically connected to the laser chip 101 via a bonding wire 181. The wiring pattern 280 is electrically connected to the wiring pattern 412 via a bonding wire 182.

The optical transceiver 1001 may include a coupler 521 for coupling an optical fiber to receive the light transmission signal SLT (FIG. 1). The optical transceiver 1501 may include a cylindrical magnet 522 around the coupler 521. The coupler 521 and the cylindrical magnet 522 may be attached to extend through the wall 512.

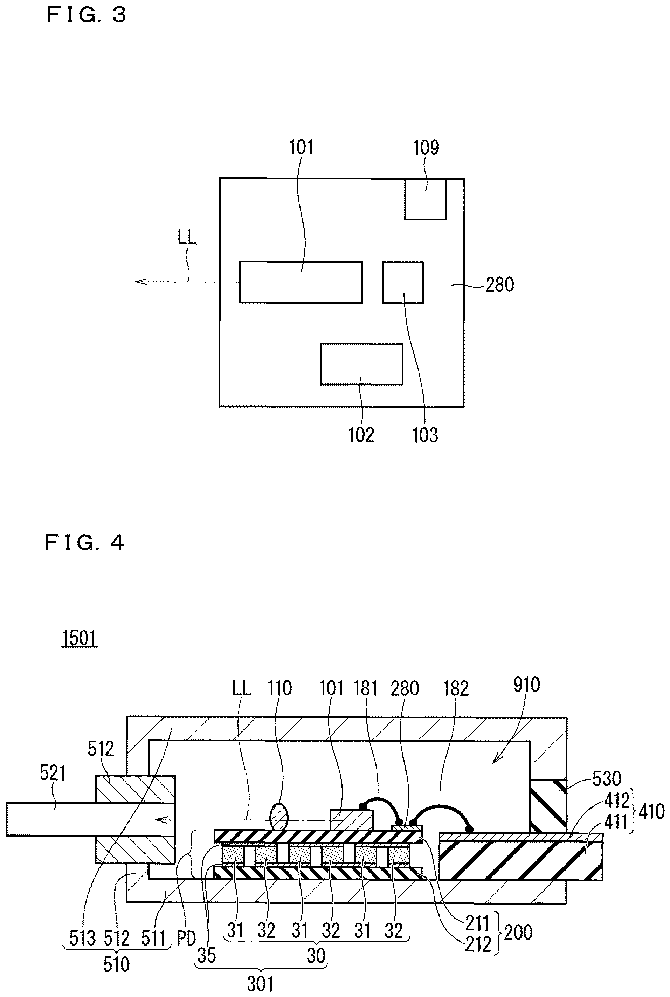

FIG. 3 is a plan view schematically showing the laser chip 101 of the optical transceiver and the wiring pattern 280, electronic components 102 and 103, and a thermistor 109 (temperature sensor) arranged around the laser chip 101. A specific pattern shape of the wiring pattern 280 is not illustrated in FIG. 3. The wiring pattern 280 may be designed according to wiring to be implemented by the wiring pattern 280. For example, the wiring pattern 280 may have a pattern shape enabling electrical connection between the bonding wire 181 and the bonding wire 182 with good properties. The wiring pattern 280 may have a pad shape for mounting of each of a plurality of terminals of the electronic component 102 or the electronic component 103. The wiring pattern 280 may have a pattern shape away from the thermistor 109 to avoid electrical connection to the thermistor 109. The electronic components 102 and 103 are capacitors, for example.

### <Embodiment 1>

FIG. 4 is a cross-sectional view schematically showing a configuration of an optical transceiver 1501 according to Embodiment 1.

The optical transceiver 1501 includes the laser chip 101, the lens 110, and at least one aluminum nitride substrate 200. Each aluminum nitride substrate herein has a single layer structure. In other words, one aluminum nitride substrate includes a single aluminum nitride member and does not include a plurality of aluminum nitride members bonded together via any adhesive material different from aluminum nitride. In Embodiment 1, the at least one aluminum nitride substrate 200 includes a plurality of aluminum nitride substrates 200 including an aluminum nitride substrate 211 (a first aluminum nitride substrate in the present embodiment) and an aluminum nitride substrate 212 (a second aluminum nitride substrate in the present embodiment). The aluminum nitride substrate 211 has an upper surface (a first surface) to which the laser chip 101 is mounted and a lower surface (a second surface opposite the first surface). The upper surface of the aluminum nitride substrate 211 may be a flat surface. The flat surface is herein a surface not having intentional irregularities. The flat surface may thus have fine irregularities of a size similar to a crystalline diameter of a sintered member as the aluminum nitride substrate 211. The flat surface may have slight warpage occurring when the sintered member as the aluminum nitride substrate 211 is manufactured.

In Embodiment 1 (FIG. 4), the lens 110 is stacked over and the laser chip 101 is mounted to the upper surface of the aluminum nitride substrate 211 without being separated by any of the aluminum nitride substrates 200 of the optical transceiver 1501.

The Peltier element PD includes the pair of aluminum nitride substrates and the body 301 supported between them. In the present embodiment, the above-mentioned pair of aluminum nitride substrates includes the aluminum nitride substrate 211 and the aluminum nitride substrate 212. The aluminum nitride substrate 212 is disposed away from the aluminum nitride substrate 211 in one direction (a downward direction in FIG. 4) and faces the lower surface of the aluminum nitride substrate 211. The body 301 is attached to the lower surface of the aluminum nitride substrate 211 to cool the laser chip 101. The body 301 includes the plurality of semiconductor members 30 and the plurality of metal members 35. The plurality of metal members 35 include the at least one metal member (first metal member) disposed on one side (an upper side in FIG. 4) in the thickness direction (a vertical direction in FIG. 4) and the at least one metal member (second metal member) disposed on the other side (a lower side in FIG. 4) in the thickness direction. The semiconductor members 30 are each sandwiched between metal members 35. The first and second metal members are each in contact with a semiconductor member 30. The first and second metal members sandwich the semiconductor members 30 in the thickness direction. The plurality of semiconductor members 30 include the p type semiconductor members 31 and the n type semiconductor members 32. The p type semiconductor members 31 and the n type semiconductor members 32 are alternatingly connected in series via the metal members 35. The aluminum nitride substrate 211 and the aluminum nitride substrate 212 sandwich the body 301. In other words, the body 301 is disposed between the aluminum nitride substrate 211 and the aluminum nitride substrate 212.

The optical transceiver 1501 includes the heat sink 511. The heat sink 511 supports the aluminum nitride substrate 212 of the Peltier element PD and includes metal. The aluminum nitride substrate 212 may be adhered to the heat sink 511 with an adhesive layer (not illustrated) including a different material from aluminum nitride, and the adhesive layer is a silicone adhesive sheet, for example. The heat sink 511 constitutes the housing 510 having the sealed internal space together with the wall 512 and the lid 513. The lens 110 is supported by the aluminum nitride substrate 211 directly or indirectly via any spacer (not illustrated). The spacer may be made of an inexpensive material different from aluminum nitride.

The wiring pattern 280 is disposed directly on the upper surface of the aluminum nitride substrate 211. The wiring pattern 280 is electrically connected to the laser chip 101 via the bonding wire 181. The wiring pattern 280 is electrically connected to the wiring pattern 412 via the bonding wire 182. The wiring pattern 280, the electronic components 102 and 103, and the thermistor 109 may be arranged over the aluminum nitride substrate 211 as illustrated in FIG. 3.

A configuration other than the above-mentioned configuration is substantially the same as the above-mentioned configuration in the comparative example, so that the same or corresponding components bear the same reference signs, and description thereof is not repeated.

According to Embodiment 1, the lens 110 is stacked over and the laser chip 101 is mounted to the upper surface of the aluminum nitride substrate 211 without being separated by any of the aluminum nitride substrates 200 of the optical transceiver 1501. This eliminates the need for an additional aluminum nitride substrate like the aluminum nitride substrate 201 (FIG. 2: comparative example) over the upper surface of the aluminum nitride substrate 211. Member costs for the aluminum nitride substrates 200 can be reduced, and thermal resistance between the body 301 of the Peltier element PD and the laser chip 101 can be reduced, so that power consumption of the Peltier element PD can be reduced.

### <Embodiment 2>

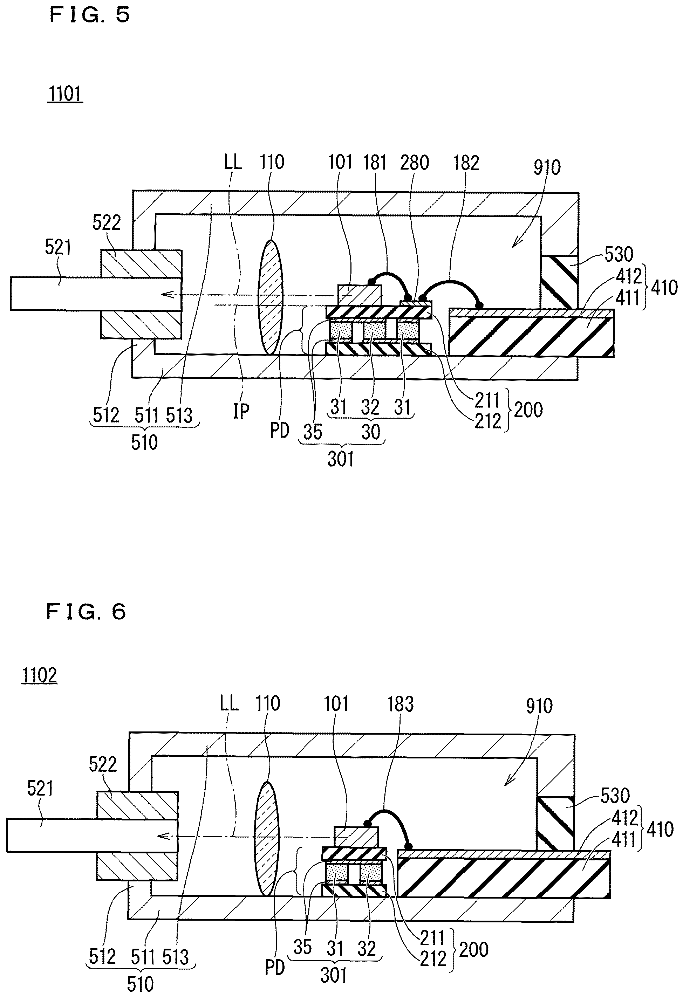

FIG. 5 is a cross-sectional view schematically showing a configuration of an optical transceiver 1101 according to Embodiment 2. In Embodiment 2 (FIG. 5), each of the aluminum nitride substrates 200 of the optical transceiver 1101 is disposed off the lens 110 in the planar layout in contrast to Embodiment 1 (FIG. 4) described above. The lens 110 is thus disposed off the aluminum nitride substrate 211 in the planar layout. The lens 110 may be disposed off the Peltier element PD in the planar layout as illustrated in FIG. 5. The lens 110 is disposed to allow the laser light LL from the laser chip 101 to pass therethrough and to intersect an imaginary plane IP including the upper surface of the aluminum nitride substrate 211 of the Peltier element PD. The lens 110 may be supported by the heat sink 511 directly or indirectly via any spacer (not illustrated). The spacer may be made of an inexpensive material different from aluminum nitride.

A configuration other than the above-mentioned configuration is substantially the same as the above-mentioned configuration in Embodiment 1 (FIG. 4), so that the same or corresponding components bear the same reference signs, and description thereof is not repeated.

According to Embodiment 2, each of the aluminum nitride substrates 200 (specifically the aluminum nitride substrate 211 and the aluminum nitride substrate 212) is disposed off the lens 110 in the planar layout. The aluminum nitride substrates 200 can thereby be reduced in size compared with a case of Embodiment 1 (FIG. 4) described above. Member costs for the aluminum nitride substrates 200 can thereby be reduced. Furthermore, since the aluminum nitride substrate 211 has a small size as described above, the body 301 for cooling the aluminum nitride substrate 211 can also have a small size. Member costs for the body 301 can thereby be reduced. Furthermore, power consumption of the Peltier element PD can be reduced as there is no need to cool the lens 110. Specifically, consumption energy relating to cooling can be reduced by reducing the size of the Peltier element PD while maintaining the ability to cool the laser chip 101.

In contrast to the optical transceiver 1001 (FIG. 2), the optical transceiver 1101 (FIG. 5) according to Embodiment 2 does not require the aluminum nitride substrate 202 (FIG. 2) as a spacer to raise a position of the laser chip 101 to allow the laser light LL from the laser chip 101 to pass through an appropriate position of the lens 110. This is because the Peltier element PD has not only a function of the cooler but also a function of the spacer in the present embodiment (FIG. 5). The aluminum nitride substrate 202 is not included, so that the size of the optical transceiver can be reduced.

### <Embodiment 3>

FIG. 6 is a cross-sectional view schematically showing a configuration of an optical transceiver 1102 according to Embodiment 3. In contrast to the optical transceiver 1101 (FIG. 5: Embodiment 2), the optical transceiver 1102 (FIG. 6) does not include the wiring pattern 280 (FIG. 5) disposed over the upper surface of the aluminum nitride substrate 211. In Embodiment 3, the wiring pattern 412 of the wiring substrate 410 is electrically connected to the laser chip 101 by a bonding wire 183 not via the wiring pattern 280. In Embodiment 3, the electronic components 102 and 103 (FIG. 3) may be mounted to the wiring substrate 410. The thermistor 109 (FIG. 3) may be disposed over the aluminum nitride substrate 211.

A configuration other than the above-mentioned configuration is substantially the same as the above-mentioned configuration in Embodiment 2 (FIG. 5), so that the same or corresponding components bear the same reference signs, and description thereof is not repeated.

According to the present embodiment, the wiring pattern 280 (FIG. 5: Embodiment 2) is not required to be disposed over the upper surface of the aluminum nitride substrate 211 (FIG. 6). The aluminum nitride substrate 211 can thereby be reduced in size compared with a case of Embodiment 2 (FIG. 5). Member costs for the aluminum nitride substrate 211 can thereby be reduced. Furthermore, since the aluminum nitride substrate 211 has a small size as described above, the body 301 for cooling the aluminum nitride substrate 211 can also have a small size. Member costs for the body 301 can thereby be reduced. Furthermore, since the body 301 has a small size, the aluminum nitride substrate 212 supporting the body 301 can also have a small size. Member costs for the aluminum nitride substrate 212 can thereby be reduced, and power consumption of the Peltier element PD can be reduced.

### <Embodiment 4>

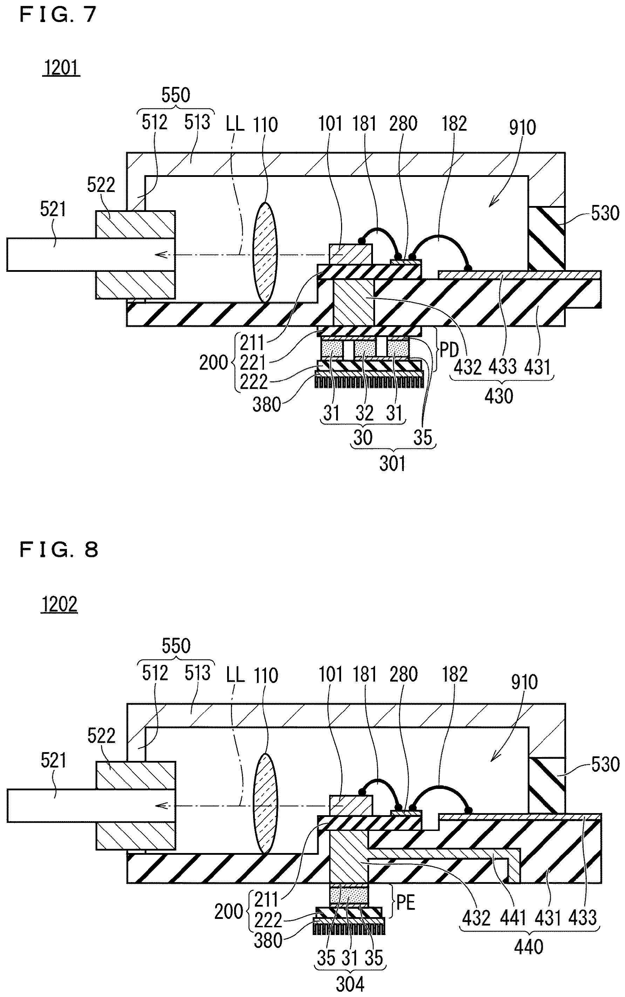

FIG. 7 is a cross-sectional view schematically showing a configuration of an optical transceiver 1201 according to Embodiment 4. The optical transceiver 1201 includes, as the at least one aluminum nitride substrate 200, the aluminum nitride substrate 211 (a first aluminum nitride substrate in the present embodiment), an aluminum nitride substrate 221 (a second aluminum nitride substrate in the present embodiment), and an aluminum nitride substrate 222 (a third aluminum nitride substrate in the present embodiment).

As in the optical transceiver 1101 (FIG. 5: Embodiment 2), the laser chip 101 is mounted to the upper surface of the aluminum nitride substrate 211 in the optical transceiver 1201 (FIG. 7). Furthermore, each aluminum nitride substrate 200 is disposed off the lens 110 in the planar layout.

The optical transceiver 1201 (FIG. 7) includes a support substrate 430 in place of the wiring substrate 410 (FIG. 5: Embodiment 2). The support substrate 430 supports the aluminum nitride substrate 211. The support substrate 430 thus supports the laser chip 101 via the aluminum nitride substrate 211. The support substrate 430 may be adhered to the aluminum nitride substrate 211 with an adhesive layer (not illustrated) including a different material from aluminum nitride, and the adhesive layer is a silicone adhesive sheet, for example.

The support substrate 430 includes at least one metal via 432 and an insulator layer 431 in which the at least one metal via is embedded. Specifically, the support substrate 430 has at least one through hole, and the at least one metal via 432 entirely fills the through hole. The through hole may extend through the support substrate 430 in the thickness direction (a vertical direction in FIG. 7). In the example illustrated in FIG. 7, the support substrate 430 includes a single metal via 432. On the other hand, the aluminum nitride substrate 221 does not include a metal via. The insulator layer 431 may be made of an inexpensive material different from aluminum nitride and is made of alumina, for example. The insulator layer 431 may alternatively be an insulator layer included in a printed circuit board (PCB), and, in this case, the support substrate 430 can be manufactured by a known PCB manufacturing method. In the example illustrated in FIG. 7, the at least one metal via 432 is one metal via 432. Each metal via 432 has an upper end (a first end) oriented toward the aluminum nitride substrate 211 (upward in FIG. 7) and a lower end (a second end opposite the first end). The upper end of the metal via 432 at least partially overlaps the aluminum nitride substrate 211 in the planar layout. In the example illustrated in FIG. 7, the upper end of the metal via 432 is contained within the aluminum nitride substrate 211 in the planar layout. The upper end of the metal via 431 may at least partially overlap the laser chip 101 in the planar layout. A wiring pattern 433 for implementing a similar function to the wiring pattern 412 (FIG. 5: Embodiment 2) is disposed over the support substrate 430. A material for the metal via 432 is not particularly limited but is preferably a material having high thermal conductivity to effectively cool the laser chip 101 by efficiently transferring heat. The thermal conductivity is preferably 100 W/m·K or more and is more preferably 200 W/m·K. Specifically, the material for the metal via 432 is a copper alloy, such as copper molybdenum and copper tungsten, tungsten, or molybdenum. When such a material is used as the material for the metal via 432, the metal via 432 and the insulator layer 431 made of alumina can be formed by co-firing. Alternatively, after the insulator layer 431 is formed without the metal via 432, the metal via 432 may be formed by plating or printing, for example. In this case, a material having higher thermal conductivity, such as silver and copper, can be used as the material for the metal via 432.

The lens 110 may be supported by the support substrate 430 directly or indirectly via any spacer (not illustrated). The spacer may be made of a different material from the support substrate 430. The spacer may include an inexpensive material different from aluminum nitride.

The support substrate 430 has, in a sealed space, a surface including a portion in which the lens 110 is directly or indirectly supported as described above and a portion in which the laser chip 101 is supported via the aluminum nitride substrate 211. These portions may be located at different positions in the thickness direction. Relative positions of the lens 110 and the laser chip 101 in the thickness direction can thereby freely be adjusted. To implement such a configuration, the insulator layer 431 of the support substrate 430 may not have a flat shape and may have a stepped shape in the sealed space as illustrated in FIG. 7.

The optical transceiver 1201 (FIG. 7) includes a housing 550 (FIG. 7) in place of the housing 510 (FIG. 5: Embodiment 2). The housing 550 does not include the heat sink 511 (FIG. 5). The housing 550 is combined with the support substrate 430 to constitute a sealed internal space.

The optical transceiver 1201 includes the Peltier element PD (cooler) connected to the lower end of the metal via 432. Specifically, the body 301 is disposed between the aluminum nitride substrate 221 and the aluminum nitride substrate 222, and the lower end of the metal via 432 and the body 301 are connected via the aluminum nitride substrate 221. The aluminum nitride substrate 221 of the Peltier element PD may be adhered to the support substrate 430 including the metal via 432 with an adhesive layer (not illustrated). The adhesive layer includes a different material from aluminum nitride and is a silicone adhesive sheet, for example.

The optical transceiver 1201 includes a heat dissipation fin 380 connected to the Peltier element PD. Specifically, the heat dissipation fin 380 is connected to the body 301 via the aluminum nitride substrate 222. The aluminum nitride substrate 222 may be adhered to the heat dissipation fin 380 with an adhesive layer (not illustrated). The adhesive layer includes a different material from aluminum nitride and is a silicone adhesive sheet, for example. A material for the heat dissipation fin 380 preferably has high thermal conductivity and preferably is aluminum, an aluminum alloy, copper, a copper alloy, or SUS.

As a modification, the heat dissipation fin 380 may not be included. Alternatively, not the heat dissipation fin 380 but the Peltier element PD may not be included to connect the heat dissipation fin 380 as the cooler to the lower end of the metal via 432 not via the Peltier element PD.

A configuration other than the above-mentioned configuration is substantially the same as the above-mentioned configuration in Embodiment 2 (FIG. 5), so that the same or corresponding components bear the same reference signs, and description thereof is not repeated.

According to the present embodiment, a configuration in which the laser chip 101 is indirectly supported can be achieved using the support substrate 430 in place of the heat sink 511 (FIG. 5). By adjusting a shape of the insulator layer 431 of the support substrate 430, the relative positions of the lens 110 and the laser chip 101 in the thickness direction can be adjusted.

Furthermore, the Peltier element PD can be disposed outside the sealed space. Heat can thereby be dissipated not via the heat sink 511 (FIG. 5: Embodiment 2), and heat dissipation from the Peltier element PD is facilitated by a method of disposing the heat dissipation fin 380 having a large size, for example. Power consumption of the Peltier element PD can thereby be reduced.

### <Embodiment 5>

FIG. 8 is a cross-sectional view schematically showing a configuration of an optical transceiver 1202 according to Embodiment 5. In contrast to the optical transceiver 1201 (FIG. 7: Embodiment 4), the optical transceiver 1202 (FIG. 8) includes a Peltier element PE in place of the Peltier element PD (FIG. 7). In contrast to the Peltier element PD, the Peltier element PE does not include the aluminum nitride substrate 221 (FIG. 7). A support substrate 440 is used in place of the support substrate 430 (FIG. 7).

The support substrate 440 includes a wiring portion 441 connected to the metal via 432. The wiring portion 441 has an end exposed outside the sealed space and has an end exposed from the lower surface of the insulator layer 431 in FIG. 8. The wiring portion 441 and the metal via 432 may be used as an electric path for applying a current to the body 304 of the Peltier element PE. A portion (the other end) of the wiring portion 441 connected to the metal via 432 may be sandwiched by the insulator layer 431 in the thickness direction as illustrated in FIG. 7.

The body 304 includes at least one semiconductor member, and each of the at least one semiconductor member is a p type semiconductor member 31. In other words, the semiconductor member of the body 304 each has a p type. The semiconductor member of the body 304 thus does not include an n type semiconductor member. As a modification, the n type semiconductor member may be used in place of the p type semiconductor member 31. In other words, the semiconductor member of the body 304 may each have an n type. In this case, the semiconductor member of the body 304 does not include the p type semiconductor member.

The p type semiconductor member 31 has a bonded surface bonded to a metal material and has a bonded surface bonded to a metal member 35 in the present embodiment. The bonded surface is electrically connected to the metal via 432 via the metal member 35.

As a modification, the p type semiconductor member 31 may have a bonded surface directly bonded to the metal via 432 not via the metal member 35. In this case, the bonded surface is naturally electrically connected to the metal via 432.

A configuration other than the above-mentioned configuration is substantially the same as the above-mentioned configuration in Embodiment 4 (FIG. 7), so that the same or corresponding components bear the same reference signs, and description thereof is not repeated.

According to the present embodiment, the aluminum nitride substrate 221 (FIG. 7: Embodiment 4) is not included, so that member costs can further be reduced.

### <Embodiment 6>

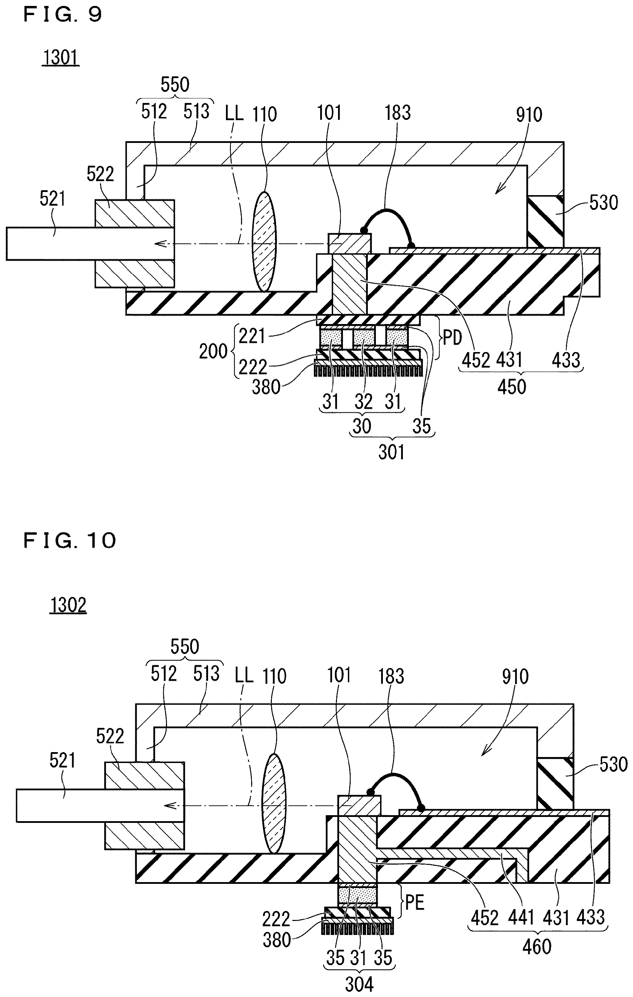

FIG. 9 is a cross-sectional view schematically showing a configuration of an optical transceiver 1301 according to Embodiment 6.

The optical transceiver 1301 includes a support substrate 450 in place of the support substrate 430 (FIG. 7: Embodiment 4). The support substrate 450 includes at least one metal via 452 in place of the at least one metal via 432 (FIG. 7: Embodiment 4). The support substrate 450 thus includes the at least one metal via 452 and the insulator layer 431 in which the at least one metal via 452 is embedded. Specifically, the support substrate 450 has at least one through hole, and the at least one metal via 452 entirely fills the through hole. The through hole may extend through the support substrate 450 in the thickness direction (a vertical direction in FIG. 7).

In contrast to the optical transceiver 1201 (FIG. 7: Embodiment 4), the optical transceiver 1301 does not include the aluminum nitride substrate 211 (FIG. 7). The laser chip 101 is mounted to the support substrate 450. The support substrate 450 thus supports the laser chip 101 not via the aluminum nitride substrate 211 (FIG. 7: Embodiment 4) in contrast to the support substrate 430 (FIG. 7: Embodiment 4).

In the example illustrated in FIG. 9, the at least one metal via 452 is one metal via 452. The metal via 452 has an upper end (a first end) oriented toward the laser chip 101 (upward in FIG. 7) and a lower end (a second end opposite the first end). The upper end of the metal via 452 at least partially overlaps the laser chip 101 in the planar layout. In the example illustrated in FIG. 9, the upper end of the metal via 452 is contained within the laser chip 101 in the planar layout. The Peltier element PD is connected to the lower end of the metal via 452 in place of the lower end of the metal via 432 (FIG. 7: Embodiment 4).

A configuration other than the above-mentioned configuration is substantially the same as the above-mentioned configuration in Embodiment 4, so that the same or corresponding components bear the same reference signs, and description thereof is not repeated.

According to the present embodiment, the aluminum nitride substrate 211 (FIG. 7: Embodiment 4) is not disposed. Member costs can thereby be reduced compared with a case of Embodiment 4 (FIG. 7).

A portion over the support substrate 450 from which the upper end of the metal via 452 is exposed is intensively cooled. The laser chip 101 is mounted to the portion to increase cooling efficiency.

### <Embodiment 7>

FIG. 10 is a cross-sectional view schematically showing a configuration of an optical transceiver 1302 according to Embodiment 7.

The optical transceiver 1302 includes a support substrate 460 in place of the support substrate 440 (FIG. 8: Embodiment 5). The support substrate 460 includes the at least one metal via 452 similar to that in a case of Embodiment 6 (FIG. 9) in place of the at least one metal via 432 (FIG. 8: Embodiment 5). The support substrate 460 further includes the wiring portion 441 similar to that in a case of Embodiment 6 (FIG. 9). The support substrate 460 thus includes the at least one metal via 452, the insulator layer 431 in which the at least one metal via 452 is embedded, and the wiring portion 441.

In contrast to the optical transceiver 1202 (FIG. 8: Embodiment 5), the optical transceiver 1302 does not include the aluminum nitride substrate 211 (FIG. 8). The laser chip 101 is mounted to the support substrate 460. The support substrate 460 thus supports the laser chip 101 not via the aluminum nitride substrate 211 (FIG. 8: Embodiment 5) in contrast to the support substrate 440 (FIG. 8: Embodiment 5).

A configuration other than the above-mentioned configuration is substantially the same as the above-mentioned configuration in Embodiment 5 (FIG. 8), so that the same or corresponding components bear the same reference signs, and description thereof is not repeated.

According to the present embodiment, the aluminum nitride substrate 211 (FIG. 8: Embodiment 5) is not disposed. Member costs can thereby be reduced compared with a case of Embodiment 5 (FIG. 8).

A portion over the support substrate 460 from which the upper end of the metal via 452 is exposed is intensively cooled. The laser chip 101 is mounted to the portion to increase cooling efficiency.

### <Simulation>

Conditions and results of simulations of temperature distribution and heat flux of an optical transceiver in an operating state will be described below. Dimensions in the figures are each in millimeters.

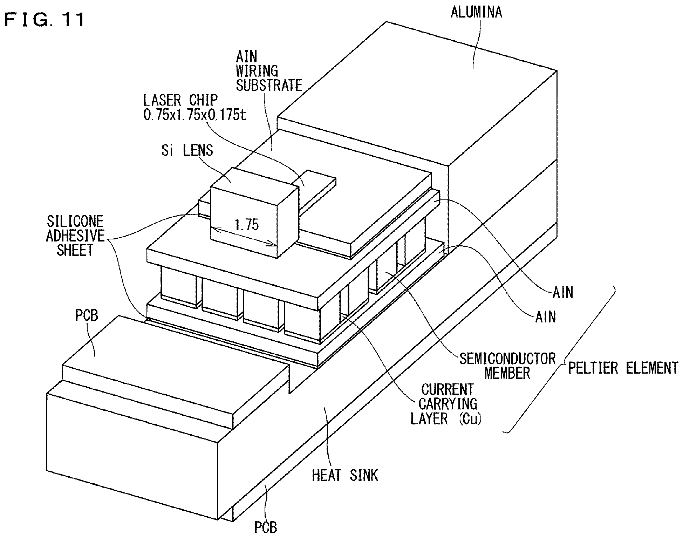

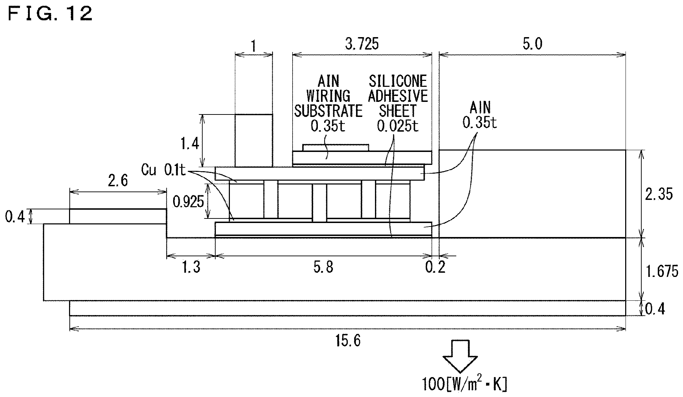

FIGs. 11 and 12 are respectively a perspective view and a side view indicating boundary conditions for simulations of a comparative example roughly corresponding to the optical transceiver 1001 (FIG. 2). The laser chip is assumed to be in the form of a cuboid having a thickness of 0.175 mm, a width of 0.75 mm, and a length of 1.75 mm, and the same applies to Examples A and B described below. Each semiconductor member of the Peltier element is assumed to be in the form of a cube 0.925 mm on each side, and the same applies to Examples A and B described below. In the comparative example, 16 semiconductor members arranged in four rows and four columns are used. The amount of heat dissipation from the lower surface is assumed to be 100 [W/m²·K] in the figures.

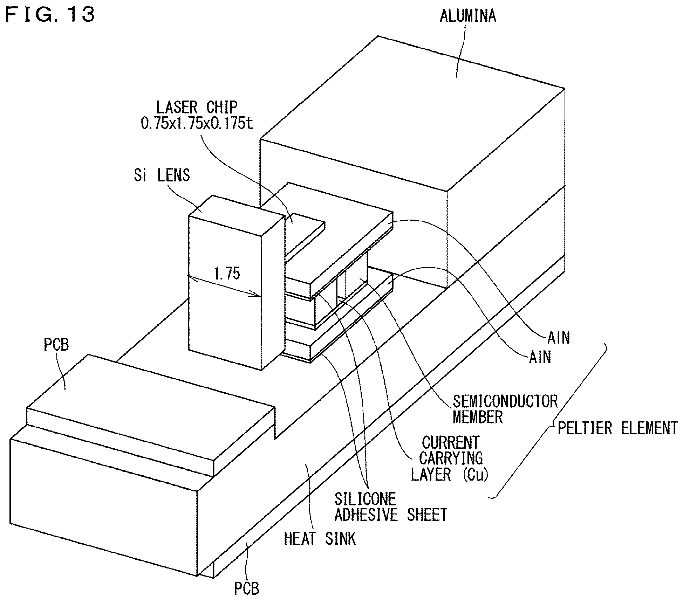

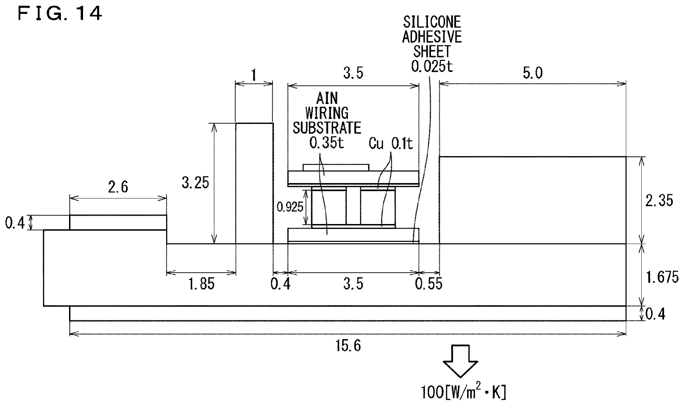

FIGs. 13 and 14 are respectively a perspective view and a side view indicating boundary conditions for simulations of Example A roughly corresponding to the optical transceiver 1101 (FIG. 5). In each of Example A and Example B described below, four semiconductor members arranged in two rows and two columns are used. The amount of heat dissipation from the lower surface is assumed to be 100 [W/m²·K] in the figures.

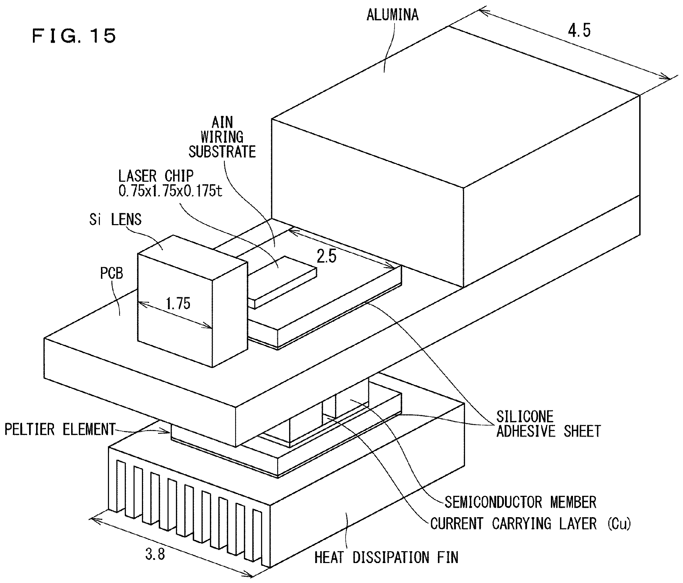

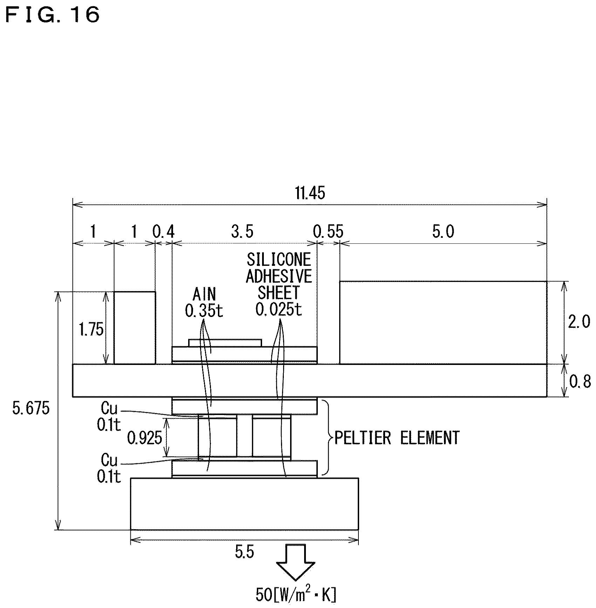

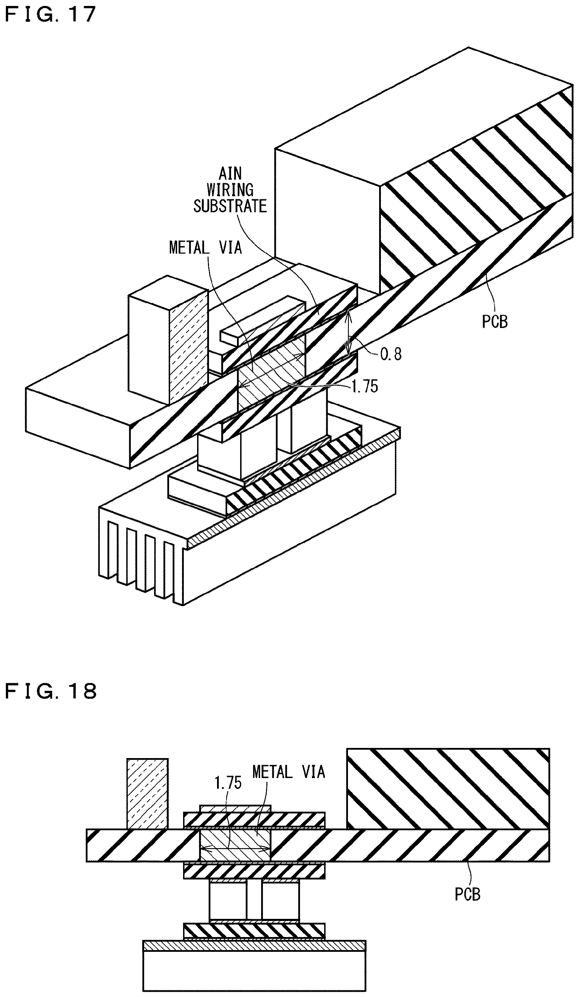

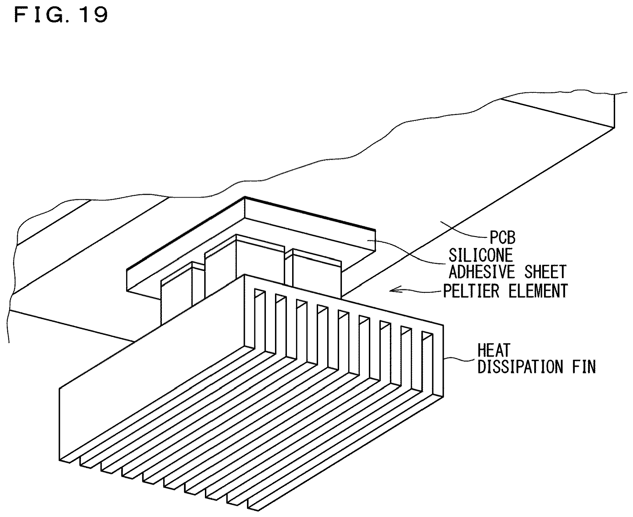

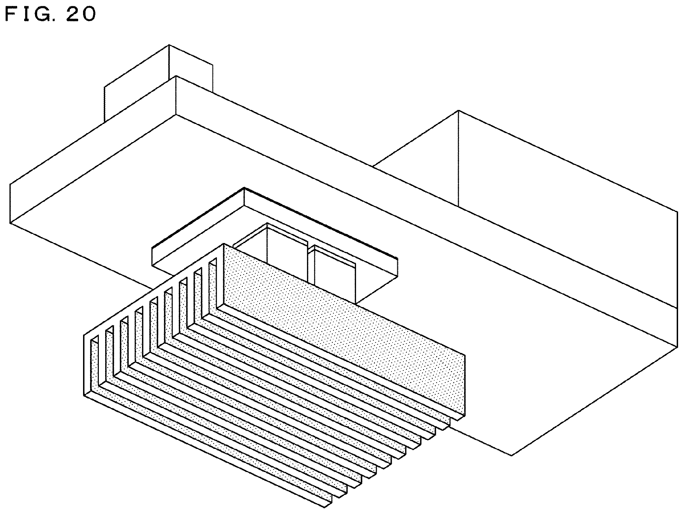

FIGs. 15 and 16 are respectively a perspective view and a side view indicating boundary conditions for simulations of Example B roughly corresponding to the optical transceiver 1201 (FIG. 7), and FIGs. 17 and 18 are cross-sectional views respectively corresponding to fields of view of FIGs. 15 and 16. FIG. 19 is a partial perspective view illustrating the boundary conditions from a different direction from that of FIG. 15, and FIG. 20 is a perspective view showing a heat dissipating portion under the boundary conditions in a dotted pattern. As illustrated in each of the cross-sectional views of FIGs. 17 and 18, a metal via similar to the metal via 432 in FIG. 7 is disposed below the laser chip to extend through the PCB as the insulator layer. The metal via is assumed to be in the form of a cuboid, and the cuboid has a height of 0.8 mm (a dimension in a vertical direction in each of FIGs. 17 and 18), a length of 1.75 mm (a dimension in a horizontal direction in FIG. 18), and a width of 0.75 mm (a dimension in a direction perpendicular to each of a direction of the height and a direction of the length). With reference to FIG. 19, the material for the heat dissipation fin is an aluminum alloy (6061). Each fin has a width of 0.2 mm, a width of a gap between fins of 0.2 mm, and a height of 1.0 mm. The amount of heat dissipation from the heat dissipating portion (in a dotted pattern in FIG. 20) is assumed to be 50 [W/m²·K].

Tables 1 and 2 below show physical property conditions for simulations.

**[Table 1]**

| | THERMAL CONDUCTIVITY [W/m·K] |
|---|---|
| AIN | 170 |
| ALUMINA | 15 |
| HEAT SINK (SUS) | 100 |
| SILICONE ADHESIVE SHEET | 10 |
| PCB, Si LENS | 0.5 |
| Cu (CURRENT CARRYING LAYER) | 400 |
| METAL VIA (Cu8O-W2O) | 250 |
| ALUMINUM ALLOY (6061) | 155 |
| PELTIER P TYPE | 1.2 |
| PELTIER N TYPE | 1.3 |

**[Table 2]**

| | SEEBECK COEFFICIENT [V/K] | RESISTIVITY [Ω·m] |
|---|---|---|
| PELTIER P TYPE | 0.00021 | 9.8×10⁻⁶ |
| PELTIER N TYPE | -0.000165 | 1×10⁻⁵ |

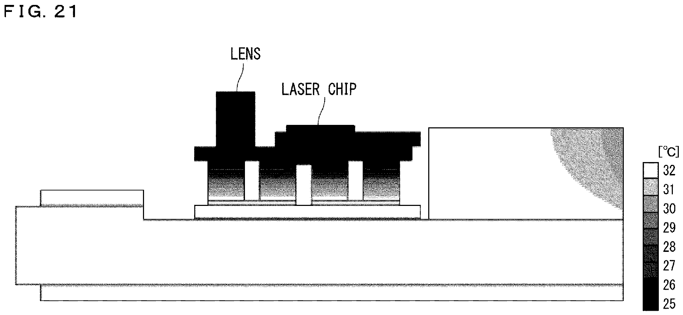

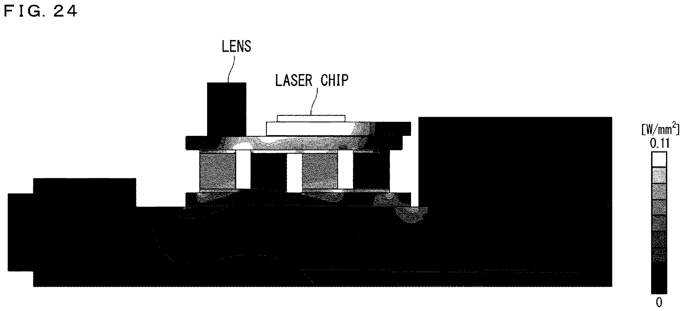

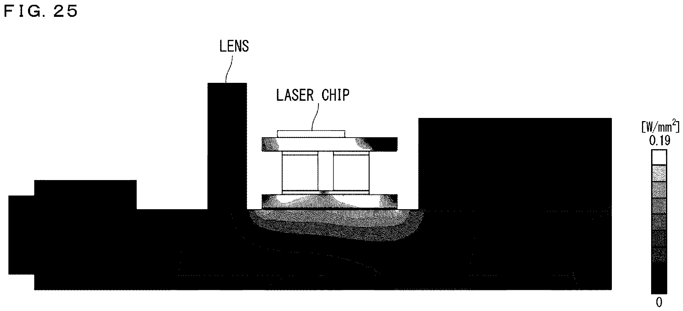

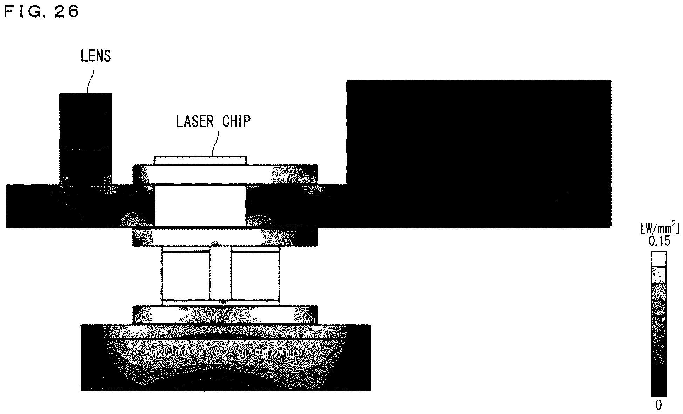

FIGs. 21, 22, and 23 are respectively cross-sectional views illustrating simulation results of temperature distribution of the comparative example, Example A, and Example B. FIGs. 24, 25, and 26 are respectively cross-sectional views illustrating simulation results of heat flux distribution of the comparative example, Example A, and Example B. The cross-sectional views of FIGs. 21 to 23 are each taken along a cross section in which the metal via does not appear, and the cross-sectional views of FIGs. 24 to 26 are each taken along a cross section in which the metal via appears.

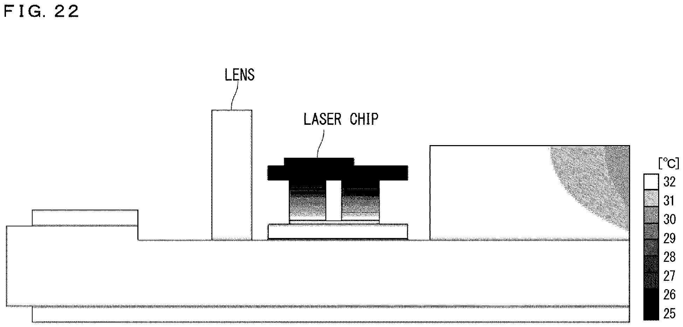

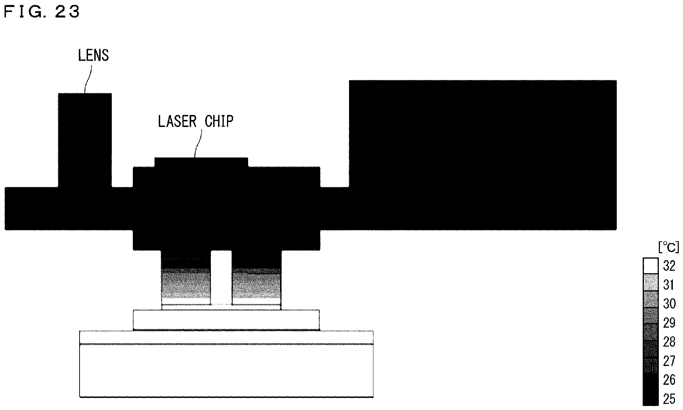

With reference to temperature distribution illustrated in FIGs. 21 to 23, the laser chip is cooled to approximately the same temperature in the comparative example (FIG. 21), Example A (FIG. 22), and Example B (FIG. 23). On the other hand, the Peltier element of the comparative example (see FIGs. 11 and 12) includes the 16 semiconductor members arranged in four rows and four columns, and the Peltier element of Example A (see FIGs. 13 and 14) and the Peltier element of Example B (see FIGs. 15 and 16) each include the four semiconductor members arranged in two rows and two columns, so that it can be seen that power consumption can be reduced in each of Examples A and B compared with that in the comparative example. In particular, in Example B (FIG. 23), (not only the laser chip but also) the lens is cooled to approximately the same temperature as that in the comparative example (FIG. 21). This is presumably because, in Example B, the lens is separated from a main heat dissipation path from the laser chip to the Peltier element by the PCB having relatively low thermal conductivity (specifically, see the insulator layer 431 in FIG. 7 as an insulator layer of the PCB) in contrast to that in Example A.

Embodiments and modifications described above may freely be combined with each other. While the present invention has been described in detail, the foregoing description is in all aspects illustrative and not restrictive. It is understood that numerous unillustrated modifications can be devised without departing from the scope of the present invention.

### EXPLANATION OF REFERENCE SIGNS

IP: imaginary plane
PD, PE: Peltier element
30: semiconductor member
31: p type semiconductor member
32: n type semiconductor member
35: metal member
101: laser chip
110: lens
181-183: bonding wire
200-203, 211, 212, 221, 222: aluminum nitride substrate
280: wiring pattern
301, 304: body
380: heat dissipation fin
410: wiring substrate
411, 431: insulator layer
412, 433: wiring pattern
430, 440, 450, 460: support substrate
432, 452: metal via
441: wiring portion
1101, 1102, 1201, 1202, 1301, 1302, 1501: optical transceiver

## Claims

1. An optical transceiver for emitting output light in response to an input electric signal, the optical transceiver comprising
a Peltier element comprising:
a first aluminum nitride substrate having a single layer structure and having a first surface and a second surface opposite the first surface;
a second aluminum nitride substrate having a single layer structure, disposed away from the first aluminum nitride substrate in one direction, and facing the second surface; and
a body supported between the first aluminum nitride substrate and the second aluminum nitride substrate, the body comprising:
at least one semiconductor member;
at least one first metal member being in contact with the at least one semiconductor member; and
at least one second metal member being in contact with the at least one semiconductor member, the at least one first metal member and the at least one second metal member sandwiching the at least one semiconductor member, the optical transceiver further comprising:
a laser chip to generate laser light, the laser chip being mounted to the first surface of the first aluminum nitride substrate of the Peltier element;
a lens disposed off the first aluminum nitride substrate in a planar layout perpendicular to the one direction, the lens being disposed to intersect an imaginary plane including the first surface of the first aluminum nitride substrate of the Peltier element and to allow the laser light from the laser chip to pass therethrough; and
a wiring pattern electrically connected to the laser chip and disposed directly on the first surface of the first aluminum nitride substrate.

2. The optical transceiver according to claim 1, wherein
the first surface of the first aluminum nitride substrate is a flat surface.

3. The optical transceiver according to claim 1 or 2, further comprising
a heat sink supporting the second aluminum nitride substrate and comprising metal.

4. An optical transceiver for emitting output light in response to an input electric signal, the optical transceiver comprising:
a laser chip to generate laser light;
a lens disposed off the laser chip in a planar layout to allow the laser light from the laser chip to pass therethrough; and
at least one aluminum nitride substrate including a first aluminum nitride substrate having a first surface to which the laser chip is mounted and a second surface opposite the first surface, each of the at least one aluminum nitride substrate being disposed off the lens in the planar layout, the optical transceiver further comprising
a support substrate supporting the first aluminum nitride substrate, the support substrate including at least one metal via and an insulator layer in which the at least one metal via is embedded, the at least one metal via having a first end oriented toward the first aluminum nitride substrate and a second end opposite the first end, the first end of the at least one metal via at least partially overlapping the first aluminum nitride substrate in the planar layout, the optical transceiver further comprising
a cooler connected to the second end of the at least one metal via, wherein
the first aluminum nitride substrate does not include a metal via.

5. The optical transceiver according to claim 4, wherein
the cooler includes a Peltier element.

6. The optical transceiver according to claim 5, wherein
the Peltier element includes at least one semiconductor member,
the at least one semiconductor member each has a p type and does not include an n type semiconductor member, or the at least one semiconductor member each has an n type and does not include a p type semiconductor member, and
the at least one semiconductor member has a bonded surface bonded to a metal material, and the bonded surface is electrically connected to the at least one metal via.

7. The optical transceiver according to any one of claims 4 to 6, wherein
the support substrate has at least one through hole, and the at least one metal via entirely fills the at least one through hole.

8. The optical transceiver according to any one of claims 4 to 6, wherein
the lens is supported by the support substrate, and the insulator layer of the support substrate comprises alumina.

9. An optical transceiver for emitting output light in response to an input electric signal, the optical transceiver comprising:
a laser chip to generate laser light; and
a support substrate supporting the laser chip, the support substrate including at least one metal via and an insulator layer in which the at least one metal via is embedded, the at least one metal via having a first end oriented toward the laser chip and a second end opposite the first end, the optical transceiver further comprising
a cooler connected to the second end of the at least one metal via, wherein
the laser chip is mounted to the support substrate, and the first end of the at least one metal via at least partially overlaps the laser chip in a planar layout,
the cooler includes a Peltier element including at least one semiconductor member, and the at least one semiconductor member each has a p type and does not include an n type semiconductor member, or the at least one semiconductor member each has an n type and does not include a p type semiconductor member, and
the at least one semiconductor member has a bonded surface bonded to a metal material, and the bonded surface is electrically connected to the at least one metal via.
